# EUROPEAN PATENT APPLICATION

(11) **EP 2 963 676 A1**
(43) Date of publication of application: **06.01.2016**
(21) Application number: 14757509.6
(22) Date of filing: 25.02.2014
(51) Int. Cl.: H01L 21/205, C23C 16/458, H01L 21/683

(54) **SUSCEPTOR**

(30) Priority: 27.02.2013 JP 2013036656
(71) Applicant: Toyo Tanso Co., Ltd., Osaka-shi, Osaka 555-0011 (JP)
(72) Inventor: NAKAYA, Satoshi, Kanonji-shi, Kagawa 769-1612 (JP)
(74) Representative: Glawe, Delfs, Moll
(86) International application number: PCT/JP2014/054459
(87) International publication number: WO 2014/132948

(57) **Abstract**

A susceptor is provided that can prevent adverse effects on the product quality of a semiconductor material by inhibiting the reaction of an auxiliary gas resulting from contact between the auxiliary gas and carbon.

The susceptor includes: a first auxiliary gas passage (10) having an inner wall made of carbon and provided between an auxiliary gas inlet port (12) for introducing an auxiliary gas to the inside; curved grooves (15) provided in a surface facing a wafer so as to extend in a curved shape and having the auxiliary gas outlet port (16); and a protection member (11), provided on at least a portion of the first auxiliary gas passage (10) so as to cover an inner wall of the auxiliary gas passage (10), and having a surface that is to be in contact with the auxiliary gas and is made of a resistant material having low reactivity with the caustic gas.

## Description

### TECHNICAL FIELD

The present invention relates to a susceptor used in a CVD apparatus for epitaxially growing a semiconductor material on a wafer, used for placing the wafer thereon.

### BACKGROUND ART

An epitaxial growth apparatus having the following structure has been proposed (see Patent Literatures 1 and 2). In the apparatus, an auxiliary gas is passed from below a wafer or a wafer placing member (hereinafter collectively referred to as "wafer or the like"), and a gas cushion is formed by the gas pressure of the auxiliary gas to levitate the wafer or the like. Also, the auxiliary gas is guided in the direction of a spiral groove to generate a gas stream in a rotational direction, so that the wafer or the like rotates in a horizontal direction.

Such an epitaxial growth apparatus can obtain a uniform semiconductor material with a simple mechanism because the levitation and the rotation of the wafer or the like can be performed by the gas stream of the auxiliary gas. In addition, another advantageous effect is that, because the same gas species as the main gas is used as the auxiliary gas, adverse effects on the product quality of the manufactured semiconductor material are lessened.

### CITATION LIST

### Patent Literature

[Patent Literature 1] Japanese Published Examined Patent Application No. H07(1995)-78276
[Patent Document 2] Japanese Published Unexamined Patent Application No. 2004-507619

### SUMMARY OF INVENTION

### TECHNICAL PROBLEM

In the epitaxial growth apparatus disclosed in Patent Literatures 1 and 2 above, the auxiliary gas used for the gas stream may often be a caustic gas reactive with graphite (i.e., a carbon material). For this reason, the auxiliary gas causes a reaction due to the contact with graphite. In particular, NN₃, H₂, and the like contained in the auxiliary gas tend to cause a reaction easily due to the contact with graphite. Thus, the auxiliary gas that has made contact with graphite is carbonized through the reaction, and therefore, the composition of the auxiliary gas may be altered, and adverse effects may be caused on the product quality of the semiconductor material. Although the susceptor surface is inhibited from causing reactions with graphite (carbon) by coating the susceptor surface with SiC or TaC, no preventive measures against the caustic gas have been provided for the auxiliary gas passage through which the auxiliary gas flows.

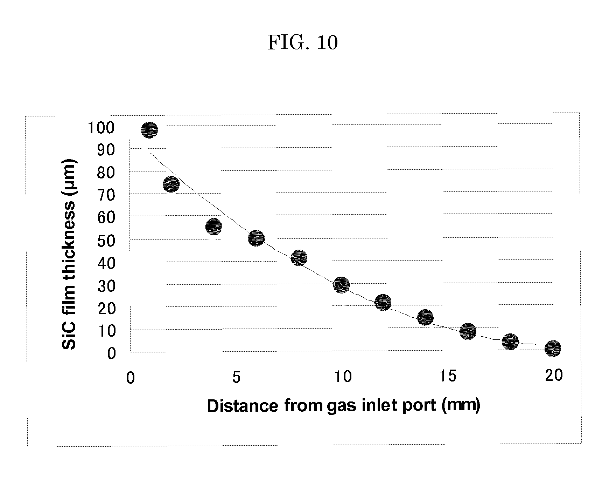

When a SiC film is formed on the outer surface of the susceptor by a CVD method, the inside of the auxiliary gas passage is not coated sufficiently. Fig. 10 shows the film thickness of an SiC film in a straight hole having an inner diameter of 3 mm when the SiC film is formed in a thickness of 100 µm on the outer surface of a susceptor using a CVD method. As clearly seen from the figure, the film thickness is already reduced to half at around a depth of 3 mm, which is the same as the inner diameter, so it is clear that the conventional CVD method can form the coating only within a small region of the auxiliary gas passage near the inlet.

Accordingly, it is an object of the present invention to provide a susceptor that can prevent adverse effects on the product quality of a semiconductor material by inhibiting the reaction of the auxiliary gas resulting from the contact between the auxiliary gas and carbon.

### SOLUTION TO PROBLEM

In order to accomplish the foregoing object, the present invention provides a susceptor used for vapor phase epitaxial growth that involves introducing a main gas for forming a semiconductor film and an auxiliary gas for levitating and rotating a wafer into a chamber, and forming a semiconductor film on the wafer by the main gas while rotating the wafer placed on a susceptor main body, characterized by comprising: an auxiliary gas passage provided in the susceptor main body and configured to pass the auxiliary gas, the auxiliary gas containing a caustic gas having a high reactivity with carbon; and a protection member provided on at least a portion of an inner wall of the auxiliary gas passage, the protection member formed separately from the susceptor main body and comprising a resistant material having a low reactivity with the caustic gas.

### ADVANTAGEOUS EFFECTS OF INVENTION

The present invention achieves the significant advantageous effect of inhibiting a reaction of an auxiliary gas resulting from the contact between the auxiliary gas and graphite inside an auxiliary gas passage for passing the auxiliary gas and thereby preventing adverse effects on the product quality of a semiconductor material.

### BRIEF DESCRIPTION OF DRAWINGS

[Fig. 1] Fig. 1 is a perspective view illustrating a susceptor of a first embodiment.
[Fig. 2] Fig. 2 is a cross-sectional view taken along line A-A in Fig. 1.
[Fig. 3] Fig. 3 is a plan view illustrating curved grooves.
[Fig. 4] Fig. 4 is schematic cross-sectional view illustrating the inside of a chamber.
[Fig. 5] Fig. 5 is a cross-sectional view illustrating a modified example of the first embodiment.
[Fig. 6] Fig. 6 is a cross-sectional view illustrating another modified example of the first embodiment.
[Fig. 7] Fig. 7 is a cross-sectional view illustrating yet another modified example of the first embodiment.
[Fig. 8] Fig. 8 is a cross-sectional view illustrating still another modified example of the first embodiment.
[Fig. 9] Fig. 9 is a cross-sectional view illustrating further another modified example of the first embodiment.
[Fig. 10] Fig. 10 is a graph illustrating the relationship between the SiC film thickness and the distance from a gas inlet port in a straight hole having an inner diameter of 3 mm when the SiC film is formed in on an outer surface of a susceptor using a CVD method.
[Fig. 11] Fig. 11 is a cross-sectional view illustrating a susceptor main body of a second embodiment.
[Fig. 12] Fig. 12 is a photograph illustrating a cross section near an auxiliary gas passage.
[Fig. 13] Fig. 13 is an enlarged view illustrating a primary portion of Fig. 11.

### DESCRIPTION OF EMBODIMENTS

The present invention provides a susceptor used for vapor phase epitaxial growth that involves introducing a main gas for forming a semiconductor film and an auxiliary gas for levitating and rotating a wafer into a chamber, and forming a semiconductor film on the wafer by the main gas while rotating the wafer placed on a susceptor main body, characterized by comprising: an auxiliary gas passage provided in the susceptor main body and configured to pass the auxiliary gas, the auxiliary gas containing a caustic gas having a high reactivity with carbon; and a protection member provided on at least a portion of an inner wall of the auxiliary gas passage, the protection member formed separately from the susceptor main body and comprising a resistant material having a low reactivity with the caustic gas.

When the susceptor is provided with a protection member composed of a resistant material having a low reactivity with a caustic gas and at least a portion of the inner wall of the auxiliary gas passage is covered with the protection member, it is possible to prevent the auxiliary gas from making contact with carbon and thereby changing its composition when the auxiliary gas passes through the auxiliary gas passage. As a result, it is possible to inhibit adverse effects on the product quality of the semiconductor material.

Note that in the case where the protection member wears, it becomes possible to recover the protection capability easily by replacing the protection member when the protection member is formed separately from the susceptor main body.

It is desirable that the protection member be provided near an upstream side end portion of the auxiliary gas passage through which the auxiliary gas flows.

Although it is preferable to provide the protection member on the entire auxiliary gas passage, there are cases in which it cannot necessarily be provided on the entire auxiliary gas passage because of cost consideration and the circumstances in forming the protection member. Even in such cases, the foregoing advantageous effects can be sufficiently obtained as long as the protection member is provided near the upstream side end portion of the auxiliary gas passage through which the auxiliary gas flows. The reason is that the reaction between carbon and the caustic gas tends to occur more easily at the region near the auxiliary gas inlet port than in the other region because the introduced auxiliary gas produces a turbulent flow at that region.

It is desirable that the resistant material comprise at least one substance selected from the group consisting of SiC, TaC, and BN.

The present invention also provides a susceptor used for vapor phase epitaxial growth that involves introducing a main gas for forming a semiconductor film and an auxiliary gas for levitating and rotating a wafer into a chamber, and forming a semiconductor film on the wafer by the main gas while rotating the wafer placed on a susceptor main body, characterized by comprising: an auxiliary gas passage provided in the susceptor main body and configured to pass the auxiliary gas, the auxiliary gas containing a caustic gas having a high reactivity with carbon; and a coating layer provided on at least a portion of an inner wall of the auxiliary gas passage, the coating layer having a low reactivity with the caustic gas.

The above-described configuration makes it possible to inhibit the auxiliary gas from making contact with carbon and thus prevent the composition of the auxiliary gas from being altered for the same reason as in the case where the protection member is provided. Therefore, it is possible to inhibit the adverse effects on the product quality of the semiconductor material.

It should be noted that in the case of forming the coating layer, the coating layer can be formed easily at low cost even when the auxiliary gas passage is narrow and long. It is preferable that the just-described configuration be applied to one in which the auxiliary gas passage has a depth from the auxiliary gas inlet port is greater than the inner diameter thereof. It is more preferable that the just-described configuration be applied to one in which the depth of the auxiliary gas passage from the auxiliary gas inlet port is at least 5 times the inner diameter thereof.

It is desirable that the coating layer be provided near an upstream side end portion of the auxiliary gas passage through which the auxiliary gas flows.

For the same reasons as discussed above, the foregoing advantageous effects can be sufficiently obtained as long as the coating layer is provided near the upstream side end portion of the auxiliary gas passage through which the auxiliary gas flows.

It is desirable that an infiltrated portion in which a substance made of the same material as that of the coating layer is infiltrated be formed on a susceptor main body side of the coating layer.

The adhesion capability of the coating layer is improved because the infiltrated portion is formed. Therefore, the coating layer does not easily peel off from the susceptor main body. In addition, the presence of the infiltrated portion can prevent the corrosion of the susceptor main body that results from the caustic gas, even when some cracks, wearing, and the like are caused in the coating layer.

It is desirable that the coating layer comprise at least one substance selected from the group consisting of SiC, TaC, and BN.

It is desirable that the auxiliary gas contain the same gas species as a gas species contained in the main gas.

When the auxiliary gas contains the same gas species as a gas species contained in the main gas, adverse effects on the product quality of the semiconductor material are further lessened in the case where the auxiliary gas and the wafer make contact with each other.

It is desirable the caustic gas be NH₃ gas and/or H₂ gas.

However, these gases are merely exemplary, and it is also possible to use NF₃ gas, CF₄ gas, CIF₃ gas, O₂ gas, O₃ gas, F₂ gas, and the like.

It is desirable that the wafer be placed on a wafer placing member.

The configuration in which the wafer is placed on the wafer placing member can inhibit the wafer and the auxiliary gas from making contact with each other. Therefore, adverse effects on the product quality of the semiconductor are further lessened.

The present invention also provides a method of manufacturing a susceptor, used for vapor phase epitaxial growth that involves introducing a main gas for forming a semiconductor film and an auxiliary gas for levitating and rotating a wafer into a chamber, and forming a semiconductor film on the wafer by the main gas while rotating the wafer placed on a susceptor main body, the susceptor including: an auxiliary gas passage provided in the susceptor main body for passing the auxiliary gas, an inner surface of the auxiliary gas passage comprising a carbonaceous material; and a coating layer provided on at least a portion of an inner wall of the auxiliary gas passage, the method comprising the steps of: coating a slurry onto the inner wall of the auxiliary gas passage, the slurry containing a resin content and metallic silicon and/or metallic tantalum dispersed in a solvent; causing the solvent in the slurry to evaporate; and causing the metallic silicon and/or the metallic tantalum to react with carbon in the carbonaceous material and carbon in the resin content by a heat treatment, to form the coating layer containing silicon carbide and/or tantalum carbide.

### EXAMPLES

Hereinbelow, the present invention will be described in further detail based on preferred embodiments thereof However, the susceptor of the present invention is not limited by the description of the following two embodiments.

### [First Embodiment]

This first embodiment shows an example in which a protection member formed separately from the susceptor main body is provided on the inner wall of the auxiliary gas passage.

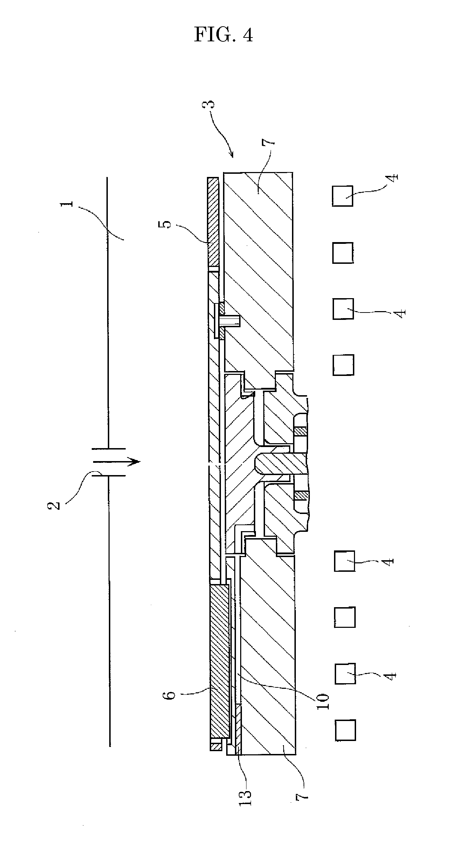

As illustrated in Fig. 4, a chamber 1 is installed in a reaction chamber housing. A main gas (gas containing a caustic gas having a high reactivity with carbon) is introduced from a main gas passage 2 into the chamber 1. A susceptor 3 is disposed in the chamber 1, and the susceptor 3 is heated from below by a heater 4.

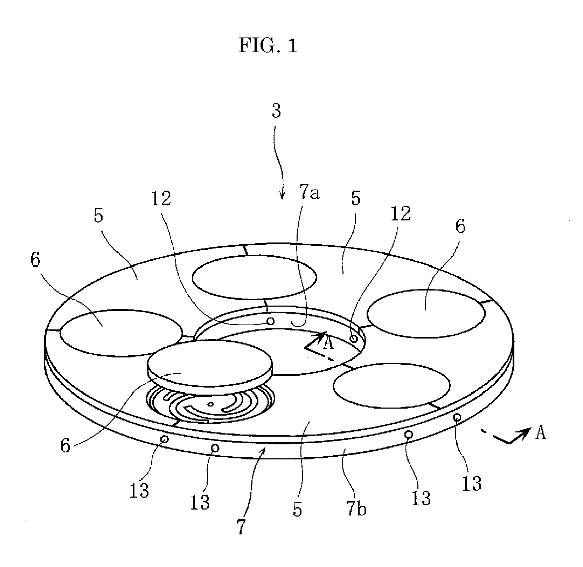

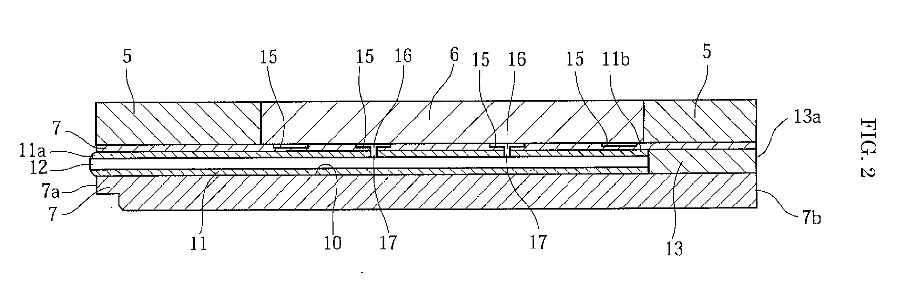

The susceptor 3 has a susceptor main body 7, as illustrated in Figs. 1 and 2, and the susceptor main body 7 is made of graphite. Positioning members 5 and wafer placing members 6, each of which is surrounded and positioned by the positioning members 5, are disposed on an upper face of the susceptor main body 7. The upper face of the wafer (not shown) to be placed on the wafer placing member 6 and the upper face of the positioning member 5 are configured to be flush with each other.

The susceptor main body 7 has a through hole (first auxiliary gas passage) 10 that passes between an outer circumferential surface 7b and an inner circumferential surface 7a of the susceptor main body 7. The diameter of the through hole 10 is set to 7 mm, and a protection member 11 that is made of SiC and covers the inner wall of the through hole 10 is inserted inside the through hole 10. Thus, the inner wall of the through hole 10 formed in the susceptor main body 7, which is made of graphite, is covered with the protection member 11, whereby the inner wall of the first auxiliary gas passage 10 is protected. As a result, when the auxiliary gas (i.e., the gas containing the same gas species as the gas species contained in the main gas) passes through the first auxiliary gas passage 10, the auxiliary gas can be prevented from making contact with graphite, and the composition of the auxiliary gas can be prevented from being altered. Therefore, it is possible to inhibit adverse effects on the product quality of the semiconductor material.

The protection member 11 has a straw-like shape. The protection member 11 is configured so that the outer diameter thereof is set to be approximately the same (diameter: 7 mm) as the inner diameter of the through hole 10, the inner diameter is set to 3 mm, and the length is set to 200 mm. An auxiliary gas inlet port 12 is formed at a tip end 11a of the inner circumferential surface 7a side of the protection member 11, and the outer shape of the tip end 11a is formed in a tapered shape. Such a shape is employed because, when the protection member 11 is inserted into the through hole 10 from the outer circumferential surface 7b of the susceptor main body 7, the protection member 11 can be inserted smoothly.

A sealing member 13 for closing the through hole 10 is inserted and fitted in the through hole 10 on the other end 11b side of the protection member 11. The sealing member 13 can prevent the auxiliary gas introduced from auxiliary gas inlet port 12 from being discharged from the through hole 10 in the outer circumferential surface 7b to the outside. An outer side face 13a of the sealing member 13 is configured to be flush with the outer circumferential surface 7b of the susceptor main body 7.

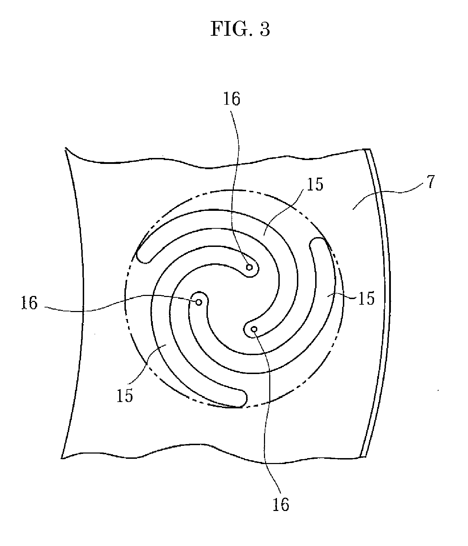

As illustrated in Fig. 3, curved grooves 15 provided so as to extend in a curved shape are formed in the upper face of the susceptor main body 7, and each of these curved grooves 15 is connected to the through hole (i.e., the first auxiliary gas passage) 10 by a second auxiliary gas passage 17. Thus, the second auxiliary gas passage 17 is connected to the curved groove 15, and this connecting portion constitutes an auxiliary gas outlet port 16.

It should be noted that after the susceptor main body 7 with the above-described structure is produced, SiC is coated on the entire susceptor main body 7 using a CVD method. This coating can be formed, for example, by forming two or more layers of SiC films on the surface of the susceptor main body 7, and purifying the outermost surface layer of these SiC films using a halogen gas such as chlorine gas.

Also, a main gas is introduced from above the chamber with a wafer placed on the wafer placing members 6, so that epitaxial growth takes place on the wafer.

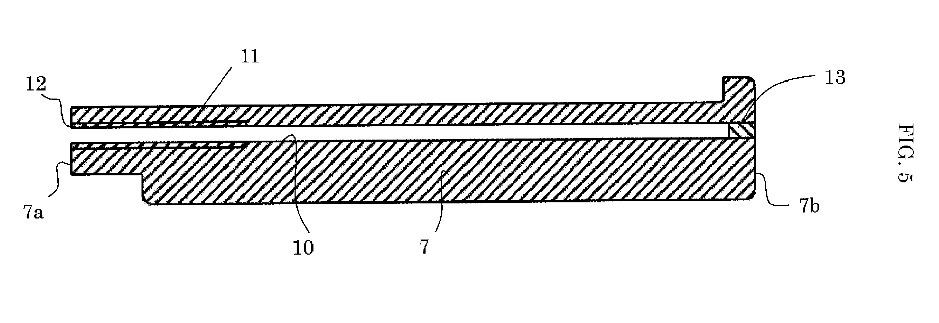

Furthermore, it is also possible to use the following methods as a method of protecting the inner wall of the through hole 10 using the protection member 11. It should be noted that the positioning members 5, the wafer placing members 6, the curved grooves 15, and so forth are not shown in Figs. 5 to 9 below for convenience in illustration, but they are the same as those in Fig. 2.

For example, as illustrated in Fig. 5, the inner diameter of the through hole 10 near the auxiliary gas inlet port 12 may be made as follows. The inner diameter of a portion of the through hole 10 that is about 50 mm from the auxiliary gas inlet port 12 is set to 7 mm, and the inner diameter of the rest of the portion is set to 3 mm. Also, a 50 mm-long straw-shaped protection member 11 (thickness: 2 mm) is inserted only into the 7 mm inner diameter portion, so that the inner wall of the through hole 10 can be covered and protected only in the portion near the auxiliary gas inlet port 12.

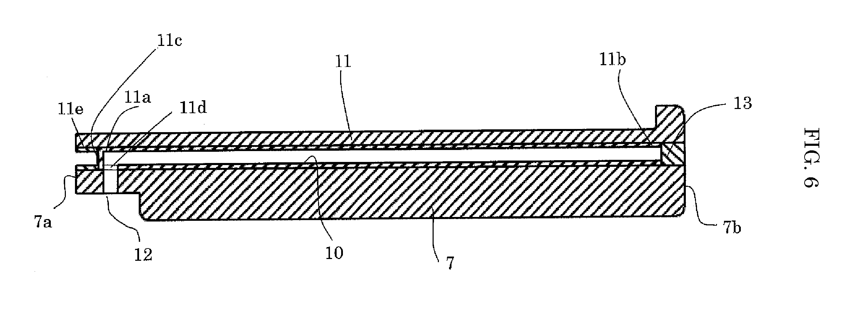

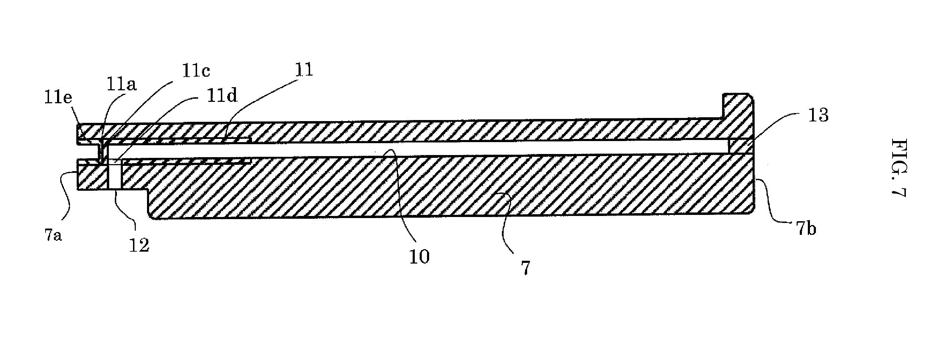

Figs. 6 to 9 show embodiments in which the auxiliary gas is introduced from an auxiliary gas source provided below the susceptor main body 7 to the auxiliary gas passage. Referring to Fig. 6, a through hole 10 for providing the protection member 11 is formed in a horizontal direction of the susceptor main body 7. A straw-shaped protection member 11 is configured so that its tip end 11a side is closed by a sealing wall 11c and an opening 11d is provided downwardly. The protection member 11 is inserted from the outer circumferential surface 7b side so that the auxiliary gas inlet port 12 and the opening 11d are allowed to communicate with each other, to thereby ensure the flow of the auxiliary gas. In addition, a sealing member 13 for closing the through hole 10 is inserted and fitted in the through hole 10 that is at the other end 11b side of the protection member 11. Furthermore, a tubular protection member 11e is fitted into the through hole 10 that is in the inner circumferential surface 7a side of the susceptor main body 7 near the tip end 11a so as to protect the inner wall of the through hole 10 that is in the inner circumferential surface 7a side of the susceptor main body 7 from the leakage of the auxiliary gas and the entry of ambient gas. Fig. 7 shows an embodiment that is substantially the same as that of Fig. 6. However, like the relationship between Fig. 2 and Fig. 5, it is different in the respect that the protection member 11 is provided only on a portion of the through hole 10.

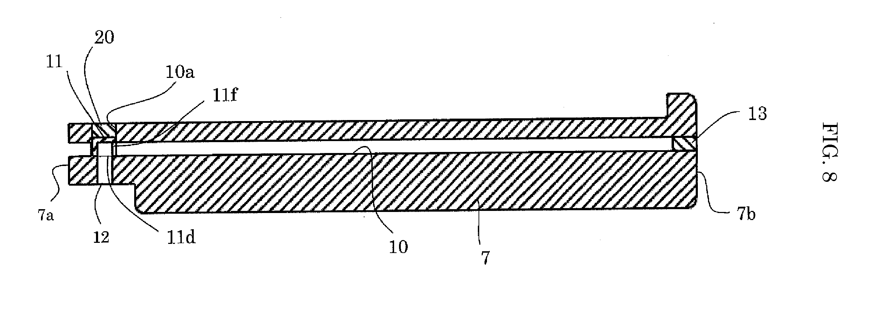

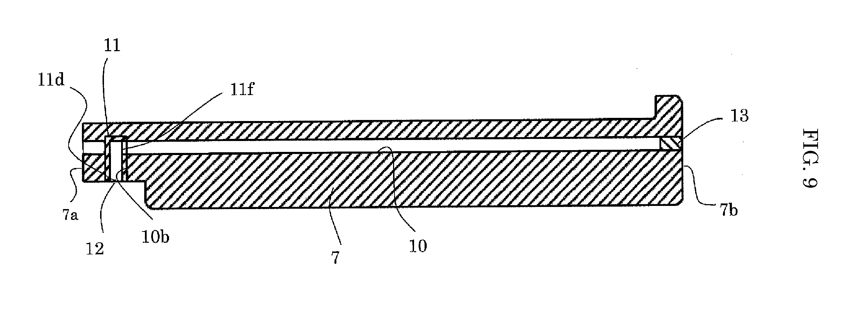

Figs. 8 and 9 show other embodiments in which the protection member 11 is provided near the auxiliary gas inlet port 12. When the auxiliary gas is introduced from below, the auxiliary gas that tends to travel in a straight direction collides with the inner wall of the auxiliary gas passage, at the location at which the flow of the auxiliary gas is changed from a vertical direction to a horizontal direction, so that the reaction of graphite is significantly promoted due to the caustic gas at that location. Therefore, sufficient effect is obtained by protecting only the location at which the collision takes place. Referring to Fig. 8, a protection member 11 is such that it has a cap-like shape having an opening 11d provided in its lower portion and an opening 11f is also provided toward the outside so that the auxiliary gas flows to the auxiliary gas passage. By providing such a protection member 11, it is possible to protect the inner wall of the portion above the auxiliary gas inlet port 12, that is, the portion at which the reaction of graphite due to the caustic gas is most likely to take place. To provide the protection member 11, a through hole 10a through which the protection member 11 can be inserted is formed at a portion of the susceptor main body 7 that is above the auxiliary gas inlet port 12, and after placing the protection member 11 at a predetermined position, the through hole 10a is closed by a sealing member 20. With such a method, the protection member 11 can be provided in a simple and easy manner.

The embodiment shown in Fig. 9 is the same as that in Fig. 8 in the respect that a protection member 11 has a cap-like shape having an opening 11d provided in its lower portion and a passage is provided in a direction toward the through hole (i.e., the first auxiliary gas passage) 10. This embodiment is different in the respect that the protection member 11 is extended downward so that the opening 11d also serves as the auxiliary gas inlet port 12. To dispose the protection member 11 with such a structure, it is sufficient that a through hole 10b should be formed in the susceptor main body 7 from below toward the first auxiliary gas passage 10 and the protection member 11 should be inserted into the through hole 10b from below. That is, the advantage is achieved that the protection member 11 can be provided in a very simple and easy manner, merely by forming the opening and the insertion of the protection member.

### [Second Embodiment]

This second embodiment shows an example in which a coating layer is formed on the inner wall of the auxiliary gas passage. That is, this embodiment has the same structure as the foregoing first embodiment except that a coating layer 20 is provided in place of the protection member 11.

The coating layer 20 was formed in the following manner.

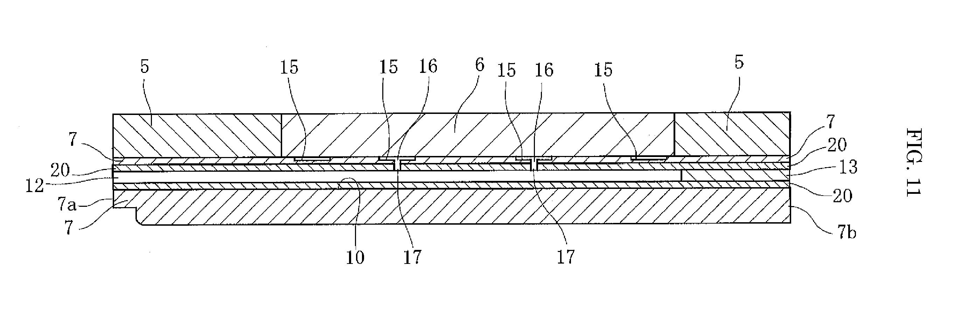

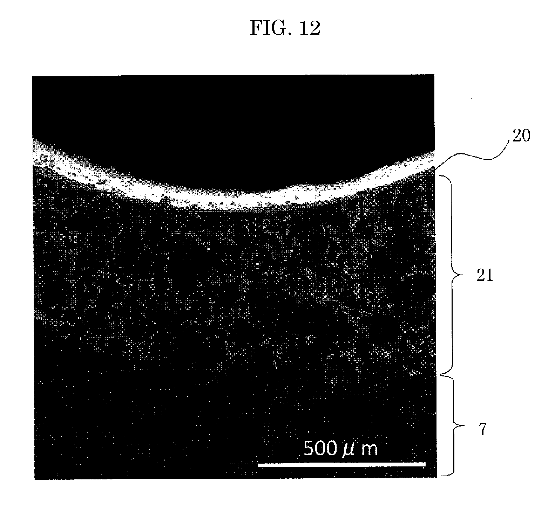

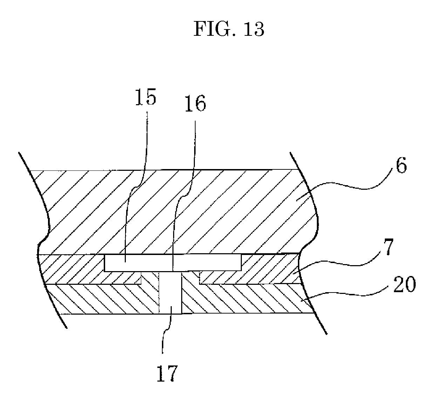

First, silicon powder (average grain size 40 µm) and 10 weight % aqueous solution of polyvinyl alcohol (PVA) were mixed and dispersed at a weight ratio of 10 : 10, to prepare a slurry. Next, the just-described slurry was put into the through hole 10 from one end of the through hole 10 with the wafer placing members 6 and a lid 13 removed, to fill the slurry in the entire through hole 10, which is the gas flow passage. Subsequently, the article was dried at 100°C for 1 hour using a dryer, and further, heat-treated at 1600°C for 1 hour under a non-oxidizing atmosphere. Thereafter, the resultant article was cooled and removed from the dryer. By this process, as illustrated in Fig. 11, the coating layer 20 made of silicon carbide (SiC) having a thickness of 10 µm was formed on the inner wall of the first auxiliary gas passage 10. Also, as clearly seen from Fig. 12, a SiC infiltration layer 21 was formed, in which SiC was infiltrated in the susceptor main body 7 to a depth of about 500 µm. Furthermore, the formation of the coating layer 20 formed of silicon carbide (SiC) was confirmed also on the inner wall of the second auxiliary gas passage 17, as illustrated in Fig. 13.

Here, when the slurry containing silicon powder and a resin content is filled in a tube, the slurry does not move greatly in the direction of gravitational force because of the surface tension as long as the tube diameter is small, even though the evaporation of the solvent proceeds at the time of drying, and the slurry keeps staying on the entire inner wall. Therefore, the slurry that has adhered to the inner wall of the through hole 10 stays on the inner wall surface, and also enters the pores in the susceptor main body 7 (carbonaceous material). When this slurry is heat-treated under a non-oxidizing atmosphere, the resin content and the metallic silicon react with each other in the slurry that has stayed on the inner wall surface, forming the coating layer 20 formed of SiC. On the other hand, the resin content and the metallic silicon of the infiltrated slurry react with each other in the pores of the susceptor main body 7 (carbonaceous material), forming an infiltrated portion 21 containing SiC. Since the SiC of the coating layer 20 and that of the infiltrated portion 21 are formed from the same slurry, the SiC in these portions is not separated but is in a continuous state.

The thickness of the coating layer 20 is not limited to the above-described thickness. However, from the viewpoint of protecting the susceptor main body 7 from the caustic gas, it is sufficient that the thickness be from 0.1 µm to 100 µm, and because it is difficult to form the coating layer in a great thickness, it is preferable that the thickness be from 0.5 µm to 50 µm, more preferably from 1 µm to 20 µm.

As described above, in a portion of the susceptor main body 7 near the coating layer 20, the infiltrated slurry reacts with the susceptor main body 7, and the SiC infiltrated portion 21 is formed. Since this infiltrated portion 21 is formed, the coating layer 20 formed of SiC is less likely to peel off. In addition, the presence of the infiltrated portion 21 can prevent corrosion of the susceptor main body 7 (carbonaceous material) that results from the caustic gas, even when some cracks, wearing, and the like are caused in the coating layer 20.

As for the thickness of the infiltrated portion 21, it is sufficient that the infiltrated portion 21 be formed to a depth of from 10 µm to 2000 µm, preferably to a depth of from 100 µm to 1000 µm

### (Other Embodiments)

(1) In the first embodiment, the entire protection member 11 is formed of a resistant material having a low reactivity with caustic gas (i.e., SiC). However, it is also possible to use a member in which a coating film of a resistant material having a low reactivity with caustic gas is coated on the surface of a straw-shaped carbon material (graphite). In this case, the coating method may be the same CVD method that is used in the case where the entire susceptor main body 7 is coated.
(2) In the first embodiment, no protection member is provided for the second auxiliary gas passage 17, but it is possible to provide the second auxiliary gas passage 17 with a protection member. However, the second auxiliary gas passage 17 is generally shorter than the first auxiliary gas passage 10. Therefore, when the entire susceptor main body 7 is coated with SiC or the like, the inner wall of the second auxiliary gas passage 17 is also coated in many cases.
(3) The method of forming the coating layer shown in the above second embodiment is not limited to the method described above. The coating layer may be formed in an appropriate method. For example, it is possible to employ a method involving coating a suspension of an organic polymer containing silicon in the molecular structure onto the inner wall of the through hole 10 and thereafter performing a heat treatment. It is also possible to employ a conversion method in which SiO₂ powder and carbon powder are uniformity mixed in a state that does not cause gravity separation, and the mixture powder is filled in the through hole 10, followed by a heat treatment.
(4) In the above second embodiment, the coating layer 20 is formed over the entirety of the first auxiliary gas passage 10, but such a structure is not to be construed as limiting. It is also possible that the coating layer may be formed only on a portion near the upstream side end portion of the first auxiliary gas passage 10, like the embodiments shown in Figs. 5, 7, 8, and 9 of the first embodiment.
(5) In the foregoing two embodiments, the susceptor main body 7 and the positioning members 5 are constructed by separate parts, but they may be integrally formed with each other.
(6) Although the foregoing two embodiments use SiC as the material for coating the entire susceptor main body 7, this is not construed as limiting, and it is sufficient that the material be a substance that has a low reactivity with a caustic gas (such as TaC and BN).
(7) In the foregoing two embodiments, epitaxial growth takes place in the condition in which the wafer is placed on the wafer placing members 6. However, it is also possible that the wafer may be placed directly on the curved grooves 15 without interposing the wafer placing members 6. In the case where the wafer is placed on the wafer placing members 6 (i.e., in the cases of the foregoing two embodiments), the wafer is placed in a pocket provided on the wafer placing members 6 so that the wafer and the wafer placing members 6 rotate together.

### INDUSTRIAL APPLICABILITY

The present invention is applicable to, for example, a vapor phase epitaxial growth apparatus.

### REFERENCE SIGNS LIST

- 3: Susceptor
- 7: Susceptor main body
- 10: Through hole (first auxiliary gas passage)
- 11: Protection member
- 12: Auxiliary gas inlet port
- 15: Curved groove
- 16: Auxiliary gas outlet port

## Claims

1. A susceptor used for vapor phase epitaxial growth that involves introducing a main gas for forming a semiconductor film and an auxiliary gas for levitating and rotating a wafer into a chamber, and forming a semiconductor film on the wafer by the main gas while rotating the wafer placed on a susceptor main body, **characterized by** comprising:
an auxiliary gas passage provided in the susceptor main body and configured to pass the auxiliary gas, the auxiliary gas containing a caustic gas having a high reactivity with carbon; and a protection member provided on at least a portion of an inner wall of the auxiliary gas passage, the protection member formed separately from the susceptor main body and comprising a resistant material having a low reactivity with the caustic gas.

2. The susceptor according to claim 1, wherein the protection member is provided near an upstream side end portion of the auxiliary gas passage through which the auxiliary gas flows.

3. The susceptor according to claim 1 or 2, wherein the resistant material comprises at least one substance selected from the group consisting of SiC, TaC, and BN.

4. A susceptor used for vapor phase epitaxial growth that involves introducing a main gas for forming a semiconductor film and an auxiliary gas for levitating and rotating a wafer into a chamber, and forming a semiconductor film on the wafer by the main gas while rotating the wafer placed on a susceptor main body, **characterized by** comprising:
an auxiliary gas passage provided in the susceptor main body and configured to pass the auxiliary gas, the auxiliary gas containing a caustic gas having a high reactivity with carbon; and a coating layer provided on at least a portion of an inner wall of the auxiliary gas passage, the coating layer having a low reactivity with the caustic gas.

5. The susceptor according to claim 4, wherein the coating layer is provided near an upstream side end portion of the auxiliary gas passage through which the auxiliary gas flows.

6. The susceptor according to claim 4 or 5, wherein an infiltrated portion in which a substance made of the same material as that of the coating layer is infiltrated is formed on a susceptor main body side of the coating layer.

7. The susceptor according to any one of claims 4 through 6, wherein the coating layer comprises at least one substance selected from the group consisting of SiC, TaC, and BN.

8. The susceptor according to any one of claims 1 through 7, wherein the auxiliary gas contains the same gas species as a gas species contained in the main gas.

9. The susceptor according to any one of claims 1 through 8, wherein the caustic gas is NH₃ gas and/or H₂ gas.

10. The susceptor according to any one of claims 1 through 9, wherein the wafer is placed on a wafer placing member.

11. A method of manufacturing a susceptor used for vapor phase epitaxial growth that involves introducing a main gas for forming a semiconductor film and an auxiliary gas for levitating and rotating a wafer into a chamber, and forming a semiconductor film on the wafer by the main gas while rotating the wafer placed on a susceptor main body, the susceptor including: an auxiliary gas passage provided in the susceptor main body for passing the auxiliary gas, an inner surface of the auxiliary gas passage comprising a carbonaceous material; and a coating layer provided on at least a portion of an inner wall of the auxiliary gas passage, the method comprising the steps of:
coating a slurry onto the inner wall of the auxiliary gas passage, the slurry containing a resin content and metallic silicon and/or metallic tantalum dispersed in a solvent;
causing the solvent in the slurry to evaporate; and
causing the metallic silicon and/or the metallic tantalum to react with carbon in the carbonaceous material and carbon in the resin content by a heat treatment, to form the coating layer containing silicon carbide and/or tantalum carbide.
